# EUROPEAN PATENT SPECIFICATION

(11) **EP 2 770 333 B1**
(45) Date of publication and mention of the grant of the patent: **22.03.2017**
(21) Application number: 14155952.6
(22) Date of filing: 20.02.2014
(51) Int. Cl.: G01R 15/20

(54) **Current sensor**
Stromsensor
Capteur de courant

(30) Priority: 20.02.2013 JP 2013031386
(43) Date of publication of application: 27.08.2014
(73) Proprietor: AISIN SEIKI KABUSHIKI KAISHA, Kariya-shi, Aichi-ken 448-8650 (JP)
(72) Inventor: Yasui, Akihiro, Kariya-shi, Aichi-ken 448-8650 (JP); Kato, Manabu, Kariya-shi, Aichi-ken 448-8650 (JP)
(74) Representative: Intès, Didier Gérard André

(56) References cited:
- US-A1- 2011 050 222

## Description

### TECHNICAL FIELD

This disclosure relates to a current sensor that measures a current flowing through a conductor.

### BACKGROUND DISCUSSION

A current for driving a motor provided in a hybrid vehicle or electric vehicle, or a current flowing through a motor of a machine tool is very large. However, a current sensor that detects such a current needs to be small-sized, light-weight, and configured as a module containing plural current sensors. However, reducing the size of the current sensor in order to satisfy these needs causes factors that may deteriorate various sensor capabilities.

For example, there is a small-sized current sensor of this type using a magnetic core. In such a current sensor, if a large current flows therein, the magnetic flux density inside the magnetic body approaches a saturation magnetic flux density, thus losing linearity of the magnetic characteristic of the magnetic body with respect to a current to be measured. As a result, the detection accuracy of the current sensor falls as the current increases. Also, the detection accuracy of such a current sensor may fall due to an external magnetic field picked up by a detector element thereof or due to the hysteresis of the magnetic body caused by residual magnetism after the current to be measured flows, other than the fall in the sensor capabilities in the case where a large current flows as described above.

If the cross-sectional area of the magnetic body is reduced by the reduction in the size of the current sensor, magnetic saturation tends to occur easily, thus deteriorating the hysteresis characteristic and lowering the shielding effect of the core against the external magnetic field. Moreover, in a three-phase motor or the like, the space with other busbars is narrowed by the reduction in size and the modular configuration of plural current sensors. Thus, the following measures have been considered (for example, JP 2008-151743A (Reference 1) and JP 2006-71457A (Reference 2)).

A current sensor disclosed in JP 2008-151743A (Reference 1) includes a conductor through which a current to be measured flows, an annular magnetic shield plate arranged to surround the conductor and having a gap, and a magneto-electric converter element arranged on the inner side of the annular magnetic shield plate. The magneto-electric converter element detects the magnetic flux density of the magnetic field due to the current. The electro-magnetic converter element is arranged near a position where the magnetic flux density of the magnetic field generated according to the current flowing through the conductor becomes minimum, between the gap of the annular magnetic shield plate and the conductor.

A current measuring device disclosed in JP 2006-71457A (Reference 2) includes a magnetic core, first and second magnetic sensors, and a current detection circuit. The magnetic core is arranged to surround a current path through which a current flows, and configured with plural gaps. The first and second magnetic sensors are arranged with different gaps from each other. The current detection circuit, when detecting the current flowing through the current path, corrects the residual magnetic flux density of the magnetic core, based on an output from the first magnetic sensor and an output from the second magnetic sensor, and thus eliminates an error due to hysteresis.

According to the technique disclosed in JP 2008-151743A (Reference 1), the magneto-electric converter element is arranged outside the gap of the magnetic shield plate, thus reducing the influence of magnetic saturation of the magnetic shield plate. To reduce the influence of magnetic saturation to a negligible level, the magnetic shield plate needs to be substantially separated away from the magneto-electric converter element and this causes an increase in the size of the magnetic sensor.

According to the technique disclosed in JP 2006-71457A (Reference 2), in the magnetic core, two substantially U-shaped magnetic bodies are arranged opposite each other, forming two gaps. In the case of such a configuration, for example, if an external magnetic field is received in a direction from one of the opposing magnetic bodies toward the other, the external magnetic field concentrated by the magnetic bodies reaches the first and second magnetic sensors, thus affecting the original measurement. Also, in order to secure an insulation distance between the two magnetic sensors and the path of the current to be measured, there is a size increase compared with the case where only one magnetic sensor is used,

Moreover, while it is conceivable that the cross-sectional area of the core may be increased in order to secure linearity when a large current flows, the core increases in size in such a case. Besides, US 2011/0050222 discloses a current sensor.

### SUMMARY

Thus, a need exists for a small-sized current sensor capable of coping with a large current and having high detection accuracy.

According to an aspect of this disclosure, a current sensor includes: a magnetic core having a groove portion formed by inner wall surfaces and adapted to receive a flat plate-like conductor through which a current to be measured flows; a detector element for detecting strength of a magnetic field, arranged at an opening of the groove portion, wherein a direction of detection of the detector element lays along a direction of a space of the groove portion. The magnetic core has: a U-shaped portion wherein the inner wall surfaces are formed parallel to each other, narrow-width portions, disposed between the U-shaped portion and the opening, wherein the inner wall surfaces get apart from each other from both ends on the side of the opening of the U-shaped portion toward the side of the opening, whereby a core width along the direction of the space of the groove portion gradually narrows and a groove width along the direction of the space of the groove portion gradually expands, and boundary portions provided between the U-shaped portion and the narrow-width portions.

According to an aspect of this disclosure, a current sensor includes: a magnetic core having a groove portion where a flat plate-like conductor through which a current to be measured flows is inserted, with a direction of plate width aligned with a direction of depth of the groove portion; and a detector element that is arranged more closely to an opening of the groove portion than the conductor in the groove portion, with a direction of detection laid along a direction of a space of the groove portion, and that detects strength of a magnetic field; wherein the core has a U-shaped portion in which a surface facing the conductor is formed parallel to a surface defining the plate width of the conductor, and narrow-width portions in which a groove width along the direction of the space of the groove portion gradually expands and a core width along the direction of the space of the groove portion gradually narrows, from both ends on the side of the opening of the U-shaped portion toward the side of the opening, and boundary portions between the U-shaped portion and the narrow-width portions are provided at a position facing the conductor.

With such a characteristic configuration, in the U-shaped portion, the groove width can be made small and therefore the cross-sectional area orthogonal to the direction of depth can be increased, thus reducing the magnetic flux density. Meanwhile, in the narrow-width portions, the groove width can be expanded to increase magnetic resistance of the groove portion, thus reducing the magnetic flux density. Therefore, since a core that does not easily become magnetically saturated can be formed, it is possible to realize a small-sized current sensor in which detection accuracy does not easily fall even if a large current flows.

It is preferable that protruding portions where the core protrudes in the direction of the space are provided to face each other at end portions on the side of the opening of the narrow-width portions, and surfaces facing each other of the protruding portions are parallel to each other, and wherein the detector element is arranged between the protruding portions.

It is preferable that the magnetic core further comprises protruding portions protruding in said direction of the space and facing each other at end portions on the side of the opening of the narrow-width portions, and that surfaces of the protruding portions facing each other are parallel to each other and the detector element is arranged between the protruding portions.

With such a configuration, the protruding portions can reduce the influence of an external magnetic field. Therefore, even if plural current sensors are arranged in an array, the influence of a magnetic field generated by another current than a current to be measured by one of the plural current sensors can be reduced. Thus, it is possible to realize a current sensor with high detection accuracy.

It is also preferable that the boundary portions are provided to face the conductor in a section on the side of the bottom of the opening, of three sections of the groove portion trisected in the direction of depth. Thus, the distance between the boundary portions and a bottom of the groove portion, measured in a depth direction, is lower than or equal to one third of the length of the groove portion in the depth direction.

With such a configuration, it is possible to secure the narrow-width portions that increase magnetic resistance of the groove portion while securing the U-shaped portion that maintains a large cross-sectional area of the core at the site where the magnetic flux density is high in the core. Therefore, since the magnetic flux density can be reduced across the U-shaped portion and the narrow-width portions, the current sensor can be used in an area where there is linearity in the relation between the current flowing through the conductor and the magnetic flux. Thus, a current sensor with high detection accuracy can be realized.

According to an aspect of this disclosure, a method of measuring a current includes: providing a current sensor as previously described; providing a flat plate-like conductor; arranging the conductor in the groove portion farther from the opening than the detector element, so that a direction of plate width of the conductor is aligned with a direction of depth of the groove portion, that a surface defining the plate width of the conductor is parallel to the inner wall surfaces of the U-shaped portion and that the conductor faces the boundary portions.

It is preferable that the conductor is arranged such that the narrow-width portions extend over the conductor on the side of the opening.

It is also preferable that the narrow-width portions extend to the side of the opening over the position of an end portion on the side of the opening of the conductor.

With such a configuration, the protruding portions can be provided more closely to the side of the opening than the conductor. Therefore, the groove width in the protruding portions is not limited to the thickness of the conductor, and the groove width in the protruding portions can be narrowed to further reduce the influence of an external magnetic field.

### BRIEF DESCRIPTION OF THE DRAWINGS

The foregoing and additional features and characteristics of this disclosure will become more apparent from the following detailed description considered with the reference to the accompanying drawings, wherein:
FIG. 1 is a perspective view schematically showing a current sensor;
FIG. 2 is a front view schematically showing the current sensor;
FIGS. 3A and 3B show the results of simulations on magnetic flux density;
FIG. 4 shows sensitivity characteristics;
FIG. 5 schematically shows a current sensor according to another embodiment;
FIG. 6 schematically shows a current sensor according to another embodiment; and
FIG. 7 schematically shows a current sensor according to another embodiment.

### DETAILED DESCRIPTION

Hereinafter, an embodiment of this disclosure will be described in detail. A current sensor 100 according to this disclosure is configured to be capable of measuring a current to be measured that flows through a conductor. Here, when a current flows through the conductor, a magnetic field is generated around the conductor as an axial center, according to the magnitude of the current (Ampere's right hand rule). The current sensor 100 detects the strength of such a magnetic field and measures the current (current value) flowing through the conductor, based on the detected strength of the magnetic field.

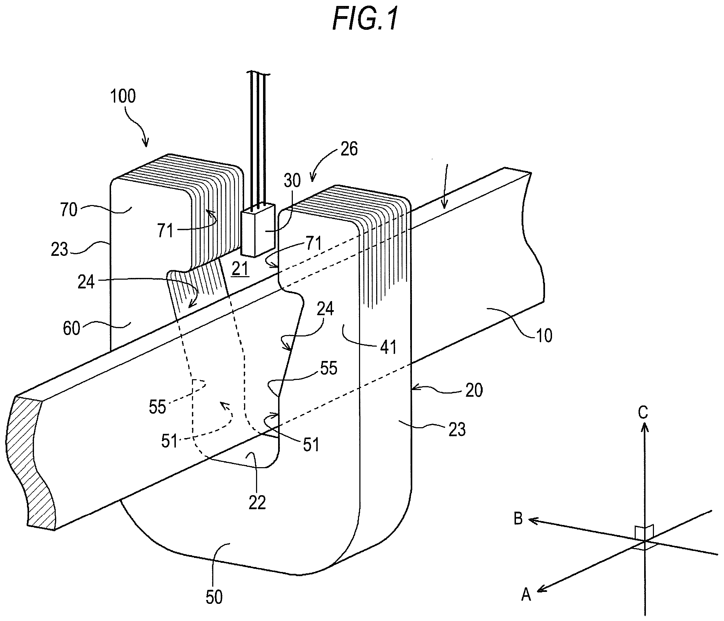

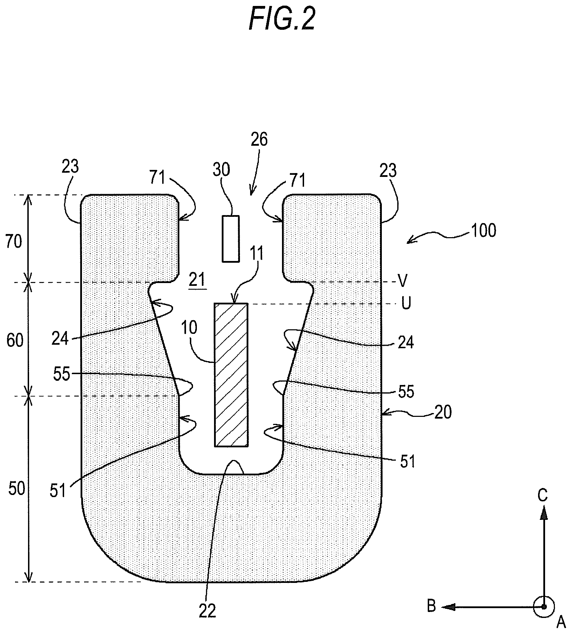

FIG. 1 shows a perspective view of the current sensor 100 according to this embodiment. In FIG. 1, a conductor 10 made of a flat plate-like conductor is shown, and the direction in which the conductor 10 extends is referred to as a direction of extension A, the direction of thickness of the conductor 10 is B, and the direction width (direction of plate width) of the conductor 10 is C. FIG. 2 schematically shows the current sensor 100, as viewed in the direction of extension A of the conductor 10. However, a lead wire provided in a detector element 30 is not shown. Hereinafter, the embodiment is described with reference to FIGS. 1 and 2.

The current sensor 100 includes a core 20 and a detector element 30. The core 20 is made of a magnetic body having a groove portion 21 where the flat plate-shaped conductor 10 through which a current to be measured flows is inserted, with the direction of plate width aligned with the direction of depth of the groove portion. The conductor 10 is formed in the shape of a flat plate, as described above. For example, a busbar used to connect a three-phase motor, not shown, with an inverter for applying electricity to the three-phase motor, is equivalent to the conductor 10. A current to be measured flows through the conductor 10 in the direction A, and the current sensor 100 measures this current.

The direction of plate width of the conductor 10 is the direction along the width of the flat plate forming the conductor 10. The direction C in FIG. 1 is equivalent to the direction of plate width. The core 20 according to this embodiment is formed by stacking flat plates having the groove portion 21 and made of a metal magnetic body, in the direction A in FIGS. 1 and 2. The metal magnetic body is a soft magnetic metal. An electromagnetic steel sheet (silicon steel sheet), permalloy, permendur or the like is equivalent to the metal magnetic body.

The core 20 is formed in such a way that the groove portion 21 is uniformly formed, as viewed in the direction A in FIGS. 1 and 2. In the core 20, the conductor 10 is inserted in such a way that, on the side of a groove bottom portion 22, surfaces of the conductor 10 parallel to an AC plane are aligned with the direction of depth (direction C) of the groove portion 21, and that the direction of stacking (direction A) of the core 20 is aligned with the direction of flow of the current to be measured. The conductor 10 inserted in the core 20 has a gap at least to inner wall surfaces 24 of the core 20. Thus, the core 20 and the conductor 10 can be insulated from each other. Therefore, it is preferable that the gap is provided according to the magnitude of the current flowing through the conductor 10.

The detector element 30 is arranged more closely to an opening 26 of the groove portion 21 than the conductor 10 in the groove portion 21, in such a way that the direction of detection is laid along the direction of the space (direction B) of the groove portion 21. The opening 26 of the groove portion 21 is an opening end of the groove portion 21. Therefore, the detector element 30 is arranged on the side closer to the opening end of the groove portion 21 than the conductor 10. Also, a gap is provided between the detector element 30 and the conductor 10 arranged in the groove portion 21 of the core 20. Thus, the detector element 30 and the conductor 10 can be insulated from each other. Here, a magnetic field generated according to the current flowing through the conductor 10 is concentrated in the core 20. Near the place where the detector element 30 is arranged, the concentrated magnetic field is a magnetic field in the direction of the space (direction B) of the groove portion 21 of the core 20.

The detector element 30 is arranged, with its direction of detection aligned with the direction B. Therefore, the detector element 30 can effectively detect the strength of the magnetic field formed by the current to be measured that flows through the conductor 10.

The core 20 according to this embodiment includes a U-shaped portion 50, narrow-width portions 60, and protruding portions 70. The U-shaped portion 50 is formed in such a way that a surface thereof facing the conductor 10 is parallel to a surface defining the plate width of the conductor 10. The U-shaped portion 50 is U-shaped as viewed in the direction A. The U-shape is not limited to a shape in which the groove bottom portion 22 is arc-shaped but also includes a shape in which a part of the arc of the groove bottom portion 22 has a straight line shape as shown in FIGS. 1 and 2. The surface facing the conductor 10 is the surface parallel to the AC plane of the surfaces of the conductor 10 and is denoted by a numeral 51 in FIG. 2. The surface defining the plate width of the conductor 10 is the surface parallel to the AC plane of the surfaces of the conductor 10. The width of the core 20 (hereinafter referred to as "core width") in the U-shaped portion 50 as viewed in the direction A may be uniform. Alternatively, the width on the side of the groove bottom portion 22 may be broader than the width on the side of the surface 51.

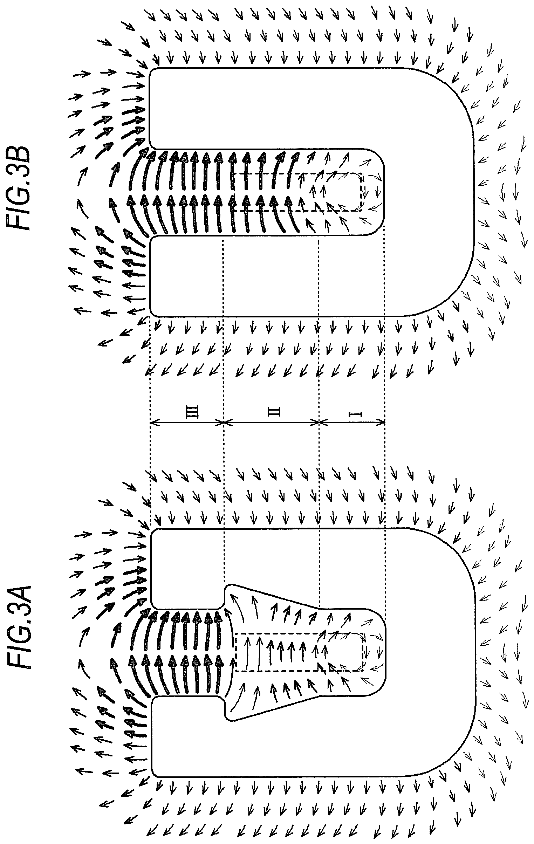

By thus forming the U-shaped portion 50, it is possible to maintain a small gap between the core 20 and the conductor 10 and to realize a large core cross-sectional area in an area I in FIG. 3A of the U-shaped portion 50. Therefore, the magnetic flux density through the core 20 can be reduced. Thus, the magnetic flux density inside the core can be reduced without increasing the size of the core 20, and magnetic flux saturation can be restrained.

The narrow-width portions 60 are formed to extend in such a way that the groove width along the direction of the space of the groove portion 21 gradually expands and the core width along the direction of the space of the groove portion 21 gradually narrows, from the end portions on the side of the opening 26 of the U-shaped portion 50 toward the side of the opening 26. The end portions on the side of the opening 26 of the U-shaped portion 50 are portions on the closest side to the opening 26, of the U-shaped portion 50. The narrow-width portions 60 extend from such portions toward the opening 26. Therefore, these portions are equivalent to boundary portions 55 between the U-shaped portion 50 and the narrow-width portions 60.

Here, in this embodiment, the surface of the U-shaped portion 50 that faces the conductor 10 is formed parallel to the surface defining the plate width of the conductor 10. Therefore, the boundary portions 55 are provided at a position facing the conductor 10. In this embodiment, the boundary portions 55 are provided to face the conductor 10, for example, in a section on the side of the bottom of the opening, of three sections of the groove portion 21 trisected in the direction of depth.

The width in the direction B of the groove portion 21 is equivalent to the groove width. The narrow-width portions 60 are formed in such a way that the groove width gradually expands, from the side of the bottom of the opening to the protruding portions 70. The side of the bottom of the opening is the side of the groove bottom portion 22 of the groove portion 21, as viewed from the side of the opening 26.

In this embodiment, the narrow-width portions 60 are provided extending to the side of the opening 26 over a position at the end portion on the side of the opening 26 of the conductor 10. The end portion on the side of the opening 26 of the conductor 10 is the closest part to the opening 26, of the parts forming the conductor 10. In this embodiment, a top end surface 11 of the conductor 10, indicated by a symbol U in FIG. 2 is equivalent to this end portion. Therefore, the narrow-width portions 60 are formed in such a way that the width in the direction B gradually expands, from the boundary portions 55 to at least the position of the top end surface 11 (position U) of the conductor 10.

Here, the core 20 according to this embodiment is formed in such a way that the groove width in the narrow-width portions 60 gradually expands toward the side of the opening 26 and that outer wall surfaces 23 on the outer side in the direction of the space in the groove portion 21 are parallel to each other. The outer side in the direction of the space is the outer side of the core 20 in the direction orthogonal to the direction B. As the outer wall surfaces 23 are thus formed parallel to each other, the core 20 can have a small size, compared with the case where the groove width is expanded without changing the cross-sectional area when cutting the core 20 vertically in the direction C. Since the groove width in the narrow-width portions 60 expands toward the opening 26, the cross-sectional area when cutting the core 20 vertically in the direction C decreases toward the opening 26. There are fewer magnetic fluxes in the core 20 as it goes toward the opening 26 of the core 20. Therefore, sensor capabilities do not easily become deteriorated even though the narrow-width portions 60 have a small cross-sectional area on the side of the opening 26. Here, the core width along the direction B in the narrow-width portions 60 is the length in the direction perpendicular to the AC plane, of the surface generated by cutting the narrow-width portions 60 vertically in the direction C.

The protruding portions 70 are provided to protrude in the direction of the space B so as to face each other at the end portions on the side of the opening 26 of the narrow-width portions 60. The end portions on the side of the opening 26 of the narrow-width portions 60 are the end portions formed in such a way that the width in the direction B gradually expands at least to the position of the top end surface 11 (position U) of the conductor 10. In FIG. 2, the protruding portions 70 are provided protruding in the direction B so as to narrow the groove width at these end portions. The position denoted by a symbol V is equivalent to this. Thus, the protruding portions 70 can reduce the influence of an external magnetic field. Therefore, for example, even if plural current sensors 100 are arranged in an array, the influence of a magnetic field generated by another current than the current to be measured by one of the plural current sensors 100 can be reduced, thus enabling realization of a current sensor 100 with high detection accuracy.

In the protruding portions 70, surfaces 71 facing each other are formed parallel to each other. In this embodiment, each of the surfaces 71 is formed to be orthogonal to the direction B. The detector element 30 is arranged between such protruding portions 70, that is, between the surfaces 71 facing each other. With such a configuration, the magnetic flux density gradient in the direction B near the detector element 30 can be made gentler. Therefore, deterioration in accuracy due to positional fluctuations of the detector element 30 can be restrained.

FIG. 3A shows the result of a simulation of magnetic fluxes acting on the core 20 of the current sensor 100 configured as described above. As a comparative example, FIG. 3B shows the result of a simulation on a conventional core 20 without having the narrow-width portions 60. To facilitate understanding, in FIGS. 3A and 3B, the magnitude of magnetic fluxes is shown with bolder lines indicating greater magnetic fluxes. In practice, magnetic fluxes are generated within the core 20, but not shown in FIGS. 3A and 3B.

In the following description, the area of parts facing each other of the U-shaped portion 50 is referred to as an area I, the area corresponding to the narrow-width portions 60 is referred to as an area II, and the area corresponding to the protruding portions 70 is referred to as an area III. Also, the respective parts of the core 20 without having the narrow-width portions 60 are similarly referred to as areas I to III, so as to correspond to the core 20 of the embodiment.

As shown in FIG. 3B, in the area I, the magnetic flux density of the magnetic fluxes entering and exiting the core 20 is smaller than in the areas II and III. Therefore, in the area I, expanding the cross-sectional area of the core is more effective for restraining magnetic saturation, rather than expanding the groove width in the narrow-width portions 60 to increase the magnetic resistance of the groove portion 21 as shown in the area II in FIG. 3A. In the core 20 according to the embodiment, the magnetic flux density in the area II is small, as shown in FIG. 3A. Thus, it has been found that magnetic saturation can be restrained by the above configuration.

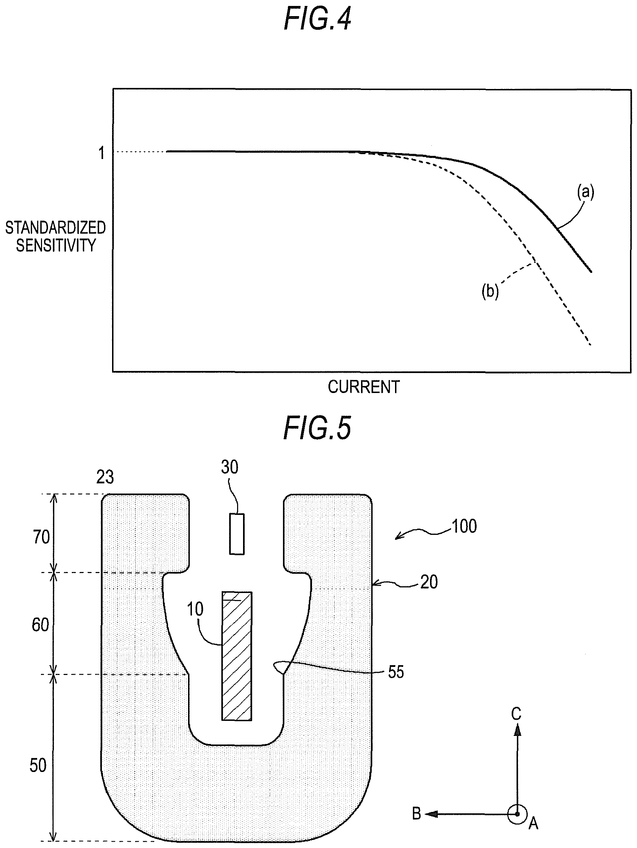

FIG. 4 shows sensitivity characteristics. The characteristic of the current sensor 100 according to the embodiment is indicated by (a). As a comparative example, the sensitivity characteristic of a conventional current sensor having the core 20 without having the narrow-width portions 60 is indicated by (b). As shown in FIG. 4, it has been found that the current sensor 100 having the core 20 according to the embodiment can secure more linearity in sensitivity than the conventional current sensor even if the current to be measured increases. Thus, the current sensor 100 of the embodiment can accurately measure a larger current than the conventional current sensor.

### Other Embodiments

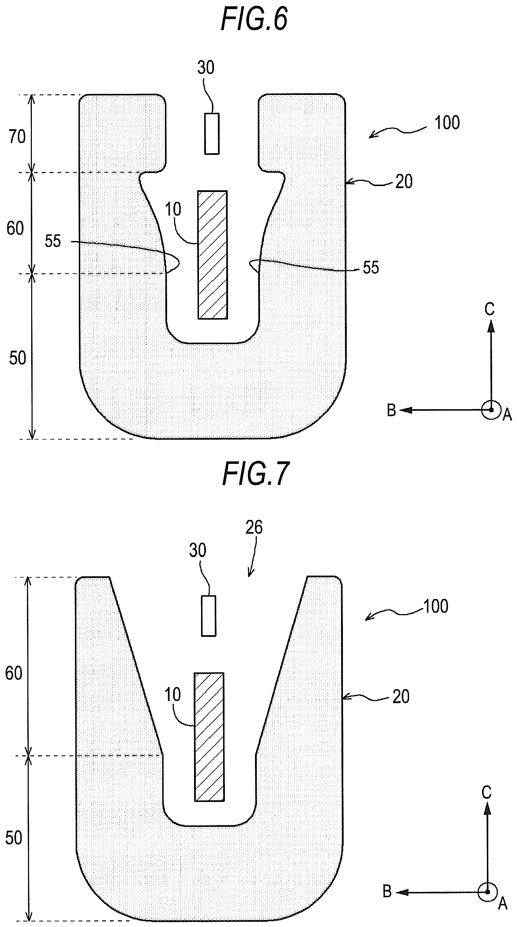

In the above embodiment, the surfaces on the side of the conductor 10 of the narrow-width portions 60 are shown in FIG. 2 as being formed in straight lines from the boundary portions 55. However, the application range of the technique disclosed here is not limited to this example. The surfaces on the side of the conductor 10 of the narrow-width portions 60 may be formed in a concave shape as shown in FIG. 5 or may be formed in a convex shape as shown in FIG. 6. In such cases, as a matter of course, the narrow-width portions 60 can be formed in such a way that the groove width gradually expands.

In the above embodiment, the narrow-width portions 60 are described as extending to the side of the opening 26 over the position of the end portion (top end surface 11) on the side of the opening 26 of the conductor 10. However, the application range of the technique disclosed here is not limited to this example. As a matter of course, the narrow-width portions 60 can be formed to terminate on the side of the groove bottom portion 22 short of the position of the end portion (top end surface 11) on the side of the opening 26 of the conductor 10.

In the above embodiment, the protruding portions 70 are described as being provided at the end portions on the side of the opening 26 of the narrow-width portions 60. However, the application range of the technique disclosed here is not limited to this example. As a matter of course, the core 20 can be formed without having the protruding portions 70, as shown in FIG. 7. In such a case, the side of the opening 26 of the core 20 can terminate in the narrow-width portions 60, as shown in FIG. 7.

In the above embodiment, the surfaces 71 facing each other of the protruding portions 70 are described as being parallel to each other. However, the application range of the technique disclosed here is not limited to this example. As a matter of course, for example, the surfaces on the side of the opening 26 of the protruding portions 70 can be formed in such a way that the groove width is narrowed toward the end of the opening. Even with such a configuration, the influence of an external magnetic field from outside of the current sensor 100 can be reduced.

In the above embodiment, the boundary portions 55 are described as being provided to face the conductor 10 in a section on the side of the bottom of the opening, of three sections of the groove portion 21 trisected in the direction of depth. However, the application range of the technique disclosed here is not limited to this example. The boundary portions 55 can be provided in a section on the opening side, of the three sections of the groove portion 21 trisected in the direction of depth or may be provided in a central section, of the three sections the groove portion 21 trisected in the direction of depth.

The technique disclosed here can be used for a current sensor that measures a current flowing through a conductor.

The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the spirit of the present invention. Accordingly, it is expressly intended that all such variations, changes and equivalents which fall within the scope of the present invention as defined in the claims, be embraced thereby.

## Claims

1. A current sensor (100) comprising:
a magnetic core (20) having a groove portion (21) formed by inner wall surfaces (24) and adapted to receive a flat plate-like conductor (10) through which a current to be measured flows;
a detector element (30) for detecting strength of a magnetic field, arranged at an opening (26) of the groove portion (21), wherein a direction of detection of the detector element (30) lays along a direction of a space of the groove portion;
wherein the magnetic core (20) has:
a U-shaped portion (50) wherein the inner wall surfaces (24) are formed parallel to each other,
**characterised by**
narrow-width portions (60), disposed between the U-shaped portion (50) and
the opening (26), wherein the inner wall surfaces (24) get apart from each other from both ends on the side of the opening of the U-shaped portion (50) toward the side of the opening (26), whereby a core width along the direction of the space of the groove portion gradually narrows and a groove width along the direction of the space of the groove portion gradually expands, and
boundary portions (55) provided between the U-shaped portion (50) and the narrow-width portions (60).

2. The current sensor according to claim 1, wherein the magnetic core (20) further comprises protruding portions (70) protruding in said direction of the space and facing each other at end portions on the side of the opening of the narrow-width portions (60), wherein surfaces of the protruding portions facing each other (71) are parallel to each other and the detector element (30) is arranged between the protruding portions (70).

3. The current sensor according to claim 1 or claim 2, wherein the distance (I) between the boundary portions (55) and a bottom of the groove portion (21), measured in a depth direction (C), is lower than or equal to one third of the length (I+II+III) of the groove portion (21) in the depth direction (C).

4. A method of measuring a current, comprising:
- providing a current sensor (100) according to any one of claims 1 to 3;
- providing a flat plate-like conductor (10);
- arranging the conductor (10) in the groove portion (21) farther from the opening (26) than the detector element (30), so that a direction of plate width of the conductor is aligned with a direction of depth (C) of the groove portion (21), that a surface defining the plate width of the conductor is parallel to the inner wall surfaces (24) of the U-shaped portion (50) and that the conductor (10) faces the boundary portions (55).

5. The method of measuring a current according to claim 4, wherein the conductor (10) is arranged such that the narrow-width portions (60) extend over the conductor (10) on the side of the opening (26).

## Patentansprüche

1. Stromsensor (100), umfassend:
einen magnetischen Kern (20) mit einem Nutabschnitt (21), der durch Innenwandflächen (24) gebildet wird und dafür ausgelegt ist, einen flachen, plattenartigen Leiter (10) aufzunehmen, durch den ein zu messender Strom fließt,
ein Detektorelement (30) zum Detektieren der Stärke eines Magnetfeldes, das an einer Öffnung (26) des Nutabschnitts (21) angeordnet ist, wobei eine Detektionsrichtung des Detektorelements (30) entlang einer Richtung eines Raumes des Nutabschnitts liegt,
wobei der magnetische Kern (20) einen U-förmigen Abschnitt (50) aufweist, wobei die Innenwandflächen (24) parallel zueinander ausgebildet sind,
**gekennzeichnet durch**
Abschnitte mit geringer Breite (60), die zwischen dem U-förmigen Abschnitt (50) und der Öffnung (26) angeordnet sind, wobei die Innenwandflächen (24) von beiden Enden her auf der Seite der Öffnung des U-förmigen Abschnitts (50) in Richtung der Seite der Öffnung (26) auseinander gehen, wodurch eine Kernbreite entlang der Richtung des Raumes des Nutabschnitts allmählich schmaler wird und eine Nutbreite entlang der Richtung des Raumes des Nutabschnitts allmählich größer wird, und
Grenzabschnitte (55), die zwischen dem U-förmigen Abschnitt (50) und den Abschnitten mit geringer Breite (60) angeordnet sind.

2. Stromsensor nach Anspruch 1, wobei der magnetische Kern (20) ferner hervorstehende Abschnitte (70) umfasst, die in Richtung des Raumes hervorstehen und an Endabschnitten auf der Seite der Öffnung der Abschnitte mit geringer Breite (60) einander zugewandt sind, wobei Flächen der hervorstehenden Abschnitte, die einander zugewandt sind (71), parallel zueinander verlaufen, und das Detektorelement (30) zwischen den hervorstehenden Abschnitten (70) angeordnet ist.

3. Stromsensor nach Anspruch 1 oder Anspruch 2, wobei die Distanz (I) zwischen den Grenzabschnitten (55) und einem Boden des Nutabschnitts (21), in einer Tiefenrichtung (C) gemessen, nicht größer ist als ein Drittel der Länge (I+II+III) des Nutabschnitts (21) in der Tiefenrichtung (C).

4. Verfahren zum Messen eines Stromes, umfassend:
- Bereitstellen eines Stromsensors (100) nach einem der Ansprüche 1 bis 3,
- Bereitstellen eines flachen, plattenartigen Leiters (10),
- Anordnen des Leiters (10) in dem Nutabschnitt (21) weiter von der Öffnung (26) entfernt als das Detektorelement (30), so dass eine Richtung der Plattenbreite des Leiters auf eine Richtung der Tiefe (C) des Nutabschnitts (21) ausgerichtet ist, dass eine Oberfläche, welche die Plattenbreite des Leiters definiert, parallel zu den Innenwandflächen (24) des U-förmigen Abschnitts (50) verläuft, und dass der Leiter (10) den Grenzabschnitten (55) zugewandt ist.

5. Verfahren zum Messen eines Stromes nach Anspruch 4, wobei der Leiter (10) so angeordnet ist, dass sich die Abschnitte mit geringer Breite (60) auf der Seite der Öffnung (26) über den Leiter (10) erstrecken.

## Revendications

1. Capteur de courant (100) comportant :
un noyau magnétique (20) ayant une partie de rainure (21) formée par des surfaces de paroi intérieure (24) et prévue pour recevoir un conducteur en forme de plaque plate (10) à travers lequel un courant devant être mesuré circule ;
un élément de détecteur (30) destiné à détecter la force d'un champ magnétique, disposé au niveau d'une ouverture (26) de la partie de rainure (21), dans lequel une direction de détection de l'élément de détecteur (30) s'étend le long d'une direction d'un espace de la partie de rainure ;
dans lequel le noyau magnétique (20) a :
une partie en forme de U (50) dans laquelle les surfaces de paroi intérieure (24) sont formées de manière parallèle l'une à l'autre,
**caractérisé par**
des parties de faible largeur (60), disposées entre la partie en forme de U (50) et l'ouverture (26), dans lesquelles les surfaces de paroi intérieure (24) se séparent l'une de l'autre depuis les deux extrémités sur le côté de l'ouverture de la partie en forme de U (50) vers le côté de l'ouverture (26), de sorte qu'une largeur de noyau le long de la direction de l'espace de la partie de rainure se rétrécit progressivement et une largeur de rainure le long de la direction de l'espace de la partie de rainure augmente progressivement, et
des parties de limite (55) prévues entre la partie en forme de U (50) et les parties de faible largeur (60).

2. Capteur de courant selon la revendication 1, dans lequel le noyau magnétique (20) comporte en outre des parties saillantes (70) qui dépassent dans ladite direction de l'espace et se faisant face au niveau de parties d'extrémité sur le côté de l'ouverture des parties de faible largeur (60), dans lequel des surfaces des parties saillantes se faisant face (71) sont parallèles l'une à l'autre et l'élément de détecteur (30) est disposé entre les parties saillantes (70).

3. Capteur de courant selon la revendication 1 ou la revendication 2, dans lequel la distance (I) entre les parties de limite (55) et un fond de la partie de rainure (21), mesurée dans une direction de profondeur (C), est inférieure ou égale à un tiers de la longueur (I+II+III) de la partie de rainure (21) dans la direction de profondeur (C).

4. Procédé de mesure d'un courant, comportant le fait de :
- prévoir un capteur de courant (100) selon l'une quelconque des revendications 1 à 3 ;
- prévoir un conducteur en forme de plaque plate (10) ;
- disposer le conducteur (10) dans la partie de rainure (21) plus loin de l'ouverture (26) que l'élément de détecteur (30), de telle sorte qu'une direction de largeur de plaque du conducteur est alignée avec une direction de profondeur (C) de la partie de rainure (21), qu'une surface définissant la largeur de plaque du conducteur est parallèle aux surfaces de paroi intérieure (24) de la partie en forme de U (50) et que le conducteur (10) fait face aux parties de limite (55).

5. Procédé de mesure d'un courant selon la revendication 4, dans lequel le conducteur (10) est disposé de telle sorte que les parties de faible largeur (60) s'étendent au-dessus du conducteur (10) sur le côté de l'ouverture (26).
